# EUROPEAN PATENT SPECIFICATION

(11) **EP 3 518 294 B1**
(45) Date of publication and mention of the grant of the patent: **15.06.2022**
(21) Application number: 17852644.8
(22) Date of filing: 28.06.2017
(51) Int. Cl.: H01L 31/05, H01L 31/0236

(54) **SOLAR CELL MODULE COMPRISING A WIRING LINE MATERIAL FOR CONNECTING SOLAR CELLS**
SOLARZELLENMODUL MIT EINEM VERDRAHTUNGSLEITUNGSMATERIAL ZUR VERBINDUNG VON SOLARZELLEN
MODULE DE CELLULE SOLAIRE COMPRENANT UN MATÉRIAU DE LIGNE DE CÂBLAGE POUR LA CONNECTION DE CELLULES SOLAIRES

(30) Priority: 20.09.2016 JP 2016182546
(43) Date of publication of application: 31.07.2019
(73) Proprietor: Kaneka Corporation, Osaka-shi, Osaka 530-8288 (JP)
(72) Inventor: KOIZUMI, Gensuke, Settsu-shi, Osaka 566-0072 (JP); TERASHITA, Toru, Settsu-shi, Osaka 566-0072 (JP)
(74) Representative: V.O.
(86) International application number: PCT/JP2017/023790
(87) International publication number: WO 2018/055863

(56) References cited:
- WO-A1-2009/041506
- WO-A1-2013/161030
- JP-A- H1 093 125
- JP-A- H08 312 089
- JP-A- H10 313 126
- JP-A- 2008 168 339
- JP-A- 2013 033 848
- JP-A- 2015 222 763
- JP-B1- S4 627 284
- US-A1- 2007 125 415
- US-A1- 2011 073 165
- US-A1- 2014 102 515
- DOUG ROSE AND SHAN DAROCZI: "DEVELOPMENT AND MANUFACTURE OF RELIABLE PV MODULES WITH >17% EFFICIENCY", 20TH EUROPEAN PHOTOVOLTAIC SOLAR ENERGY CONFERENCE, PROCEEDINGS OF THE 20TH INTERNATIONAL CONFERENCE, WIP-RENEWABLE ENERGIES, 6 June 2005 (2005-06-06), - 10 June 2005 (2005-06-10), pages 2406-2409, XP040511841, ISBN: 978-3-936338-19-5
- DAVIDSEN RASMUS SCHMIDT ET AL: "Black silicon solar cells with black bus-bar strings", 2016 IEEE 43RD PHOTOVOLTAIC SPECIALISTS CONFERENCE (PVSC), IEEE, 5 June 2016 (2016-06-05), pages 2885-2888, XP033008186, DOI: 10.1109/PVSC.2016.7750183 [retrieved on 2016-11-18]

## Description

### TECHNICAL FIELD

The present invention relates to a solar cell module comprising a wiring member for connecting a plurality of solar cells.

### BACKGROUND ART

Solar cells that include crystalline semiconductor substrates such as a single-crystalline silicon substrate and a polycrystalline silicon substrate have a small area for one substrate, and thus in practical use, a plurality of solar cells are electrically connected and modularized for increasing output. In electrical connection of a plurality of solar cells, a wiring member composed of metal foil or the like is used. The wiring member is connected to electrodes arranged on a light-receiving surface and a back surface of a solar cell via a solder, conductive adhesive, etc. In a back contact solar cell in which electrodes are provided only on back surface and no electrode is provided on light-receiving surface, back surface electrodes of adjacent solar cells are electrically connected via a wiring member.

The solar cell exhibits a black color when viewed from the light-receiving side, whereas the wiring member has metallic luster. Thus, when a solar cell module is installed on a roof or a wall surface of a building, reflected light of sunlight applied to a wiring member is visible, so that the visuality is impaired. Patent Document 1 suggests that a portion exposed to the wiring member on the light-receiving side is covered with a colored resin layer to suppress deterioration of the visuality by metallic luster of the wiring member.

Patent Document 2 discloses a solar cell module comprising a solar cell string in which a plurality of solar cells each having a light-receiving surface and a back surface are electrically connected through a wiring member. In a first embodiment of said Patent Document 2, the surface of the wiring member has a recessed and projected structure obtained by roughening said surface. In a second embodiment of said Patent Document 2, a method is disclosed wherein the wiring member with an electroconductive black layer is used.

### PRIOR ART DOCUMENT

### PATENT DOCUMENT

Patent Document 1: JPH1093125 A;
Patent Document 2: JPH08312089 A

### SUMMARY OF THE INVENTION

### PROBLEMS TO BE SOLVED BY THE INVENTION

In a solar cell wiring member, a connection portion with an electrode of a solar cell is required to be electroconductive. When the wiring member is covered with an insulating resin layer, it is necessary to pattern the resin layer so that a non-connection portion with the electrode of the solar cell is selectively covered, and the connection portion with the electrode is not covered. At the time of connecting the wiring member to the solar cell, it is necessary to perform alignment so that a portion which is not covered with the resin layer is connected to the electrode of the solar cell. Thus, an increase in manufacturing cost of the wiring member, an increase in man-hour for alignment during connection of the wiring member, a reduction in yield of the wiring member or the solar cell module, etc. may occur.

In view of the above-described situation, an object of the present invention is to provide a solar cell module comprising a solar cell string in which a plurality of solar cells are electrically connected through a wiring member, with said wiring member being easily connected to an electrode of a solar cell and contributing to improvement of the visuality of a solar cell module.

### MEANS FOR SOLVING THE PROBLEMS

A solar cell module includes a solar cell string, a transparent light-receiving-surface protection member disposed on the light-receiving side of the solar cell string; a back-surface protection member disposed on a back surface of the solar cell string; and an encapsulant which is protected between the light-receiving-surface protection member and the back-surface protection member to encapsulate the solar cell string. The solar cell string includes a plurality of solar cells each having a light-receiving surface and a back surface, and a plurality of solar cells are electrically connected by a wiring member. A recessed and projected structure is formed on the light-receiving surface of the solar cell.

The wiring member for connecting the solar cell is an electroconductive member having a first principal surface, a second principal surface and lateral surfaces. The wiring member includes a base material made of a metallic material such as a copper foil, and an alloy layer or the like is disposed on a surface of the base material. The wiring member used in the solar cell module of the present invention has a recessed and projected structure on the entire surface of the first principal surface, and an electroconductive black layer is disposed on the entire surface of the first principal surface. An electroconductive black layer may be disposed on the lateral surface of the wiring member.

The electroconductive black layer is preferably a plated layer formed on a surface of the base material. The electroconductive black layer is, for example, a metal layer containing palladium. The metal layer containing palladium is formed on a surface of the wiring member by, for example, electroless plating.

In the solar cell module, the first principal surface of the wiring member is connected to a metal electrode arranged on the back surface of the solar cell. That is, in the solar cell module, the wiring member is disposed in such a manner that the first principal surface is on the light-receiving side, and the second principal surface is on the back side. The wiring member is connected to the electrode of the solar cell through an electroconductive connection material such as solder, a conductive film or a conductive paste.

The recessed and projected structure on the first principal surface of the wiring member has a triangular prism shape or a pyramidal shape, and the projections are regularly arranged. The recessed and projected structure of the light-receiving surface of the solar cell is a quadrangular pyramidal shape.

The solar cell is a so-called back contact solar cell. In the back contact solar cell, a metal electrode is not disposed on the light-receiving surface, and a metal electrode is disposed only on the back surface. When the back-surface protection member of the solar cell module is a black sheet, the entire surface of the solar cell module can be uniformly colored black, and therefore the visuality is improved.

### EFFECTS OF THE INVENTION

According to the present invention, the visuality of the solar cell module can be improved. In addition, by using a wiring member in said solar cell module of the present invention, a solar cell module having a high visuality can be formed with a simple manufacturing process, so that production efficiency can be improved, and the manufacturing cost can be reduced.

### BRIEF DESCRIPTION OF THE DRAWINGS

FIG. 1 is a schematic cross-sectional view illustrating a solar cell module according to one embodiment.
FIG. 2 is a schematic perspective view of a solar cell string.
FIG. 3A is a schematic perspective view showing recessed and projected structure of a wiring member.
FIG. 3B is a schematic perspective view showing recessed and projected structure of a wiring member.
FIG. 3C is a schematic perspective view showing recessed and projected structure of a wiring member.
FIG. 3D is a schematic perspective view showing recessed and projected structure of a wiring member.
FIG. 4 is a schematic perspective view of a solar cell string.
FIG. 5 is a schematic perspective view of a solar cell string.

### MODE FOR CARRYING OUT THE INVENTION

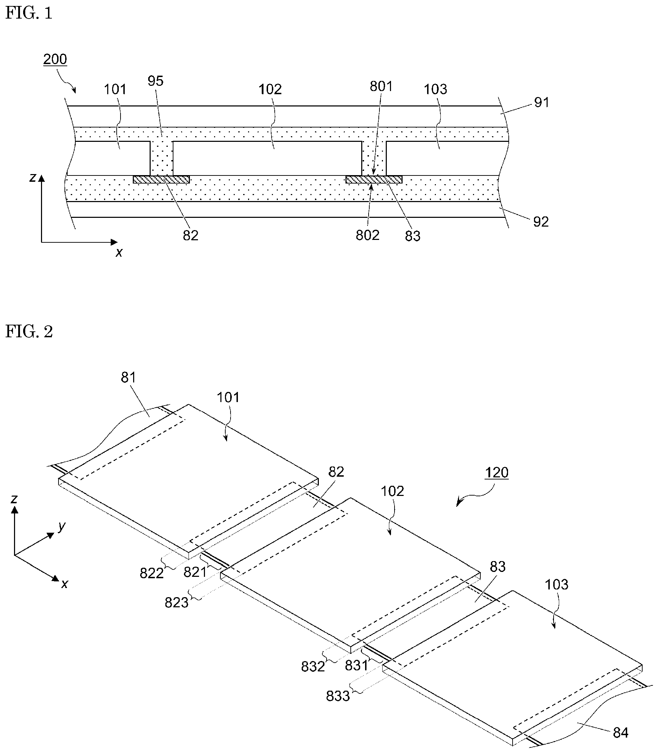

FIG. 1 is a schematic sectional view of a solar cell module (hereinafter referred to as a "module") according to one embodiment. A module 200 shown in FIG. 1 includes a solar cell string in which plurality of solar cells (hereinafter referred to as "cells") 101, 102 and 103 are electrically connected through wiring members 82 and 83.

A light-receiving-surface protection member 91 is disposed on the light-receiving side (the upper side in FIG. 1) of the solar cell string, and a back-surface protection member 92 is disposed on the back side (the lower side in FIG. 1) of the solar cell string. In the module 200, the solar cell string is encapsulated by filling the space between the protection members 91 and 92 with an encapsulant 95.

As the cell, a type of solar cells that are configured to be interconnected with a wiring member can be used, such as a crystalline silicon solar cell or a solar cell including a semiconductor substrate other than silicon such as GaAs. In the module 200 shown in FIG. 1, electrodes on the back side of a back contact solar cell are connected via wiring members 82 and 83.

The back contact solar cell has a p-type semiconductor layer and an n-type semiconductor layer on the back side of a semiconductor substrate, and a metal electrode is disposed on each of the p-type semiconductor layer and the n-type semiconductor layer. The back contact solar cell does not have a metal electrode on the light-receiving surface of the semiconductor substrate, and photocarriers (holes and electrons) generated in the semiconductor substrate are collected by the metal electrode disposed on the back side of the semiconductor substrate. Thus, a solar cell string is formed by connecting electrodes disposed on the back side of the cell by a wiring member. Since the back contact solar cell does not have a metal electrode on the light-receiving surface, the entire surface of the cell is uniformly colored black when the cell is viewed from the light-receiving side, so that an excellent visuality is exhibited.

The light-receiving surface of the cell has a recessed and projected structure for improving conversion efficiency by increasing the amount of light captured in the semiconductor substrate. The shape of the projection is preferably a quadrangular pyramidal shape. The quadrangular pyramid-shaped projections are formed by, for example, subjecting a surface of the single-crystalline silicon substrate to anisotropic etching treatment. The height of the projection on the light-receiving surface of the cell is, for example, about 0.5 to 10 µm, preferably about 1 to 5 µm. The back surface of the cell may also have a recessed and projected structure.

The metal electrode can be formed by a known method such as printing or plating. For example, an Ag electrode formed by screen printing of an Ag paste, a copper-plated electrode formed by electroplating, or the like is preferably used.

FIG. 2 is a schematic perspective view of a solar cell string 120 in which cells 101 and 102 are electrically connected through the wiring member 82, and cells 102 and 103 are electrically connected through the wiring member 83. One end portion 822 of the wiring member 82 is connected to the back electrode of the cell 101, and the other end portion 823 of the wiring member 82 is connected to the back electrode of the cell 102. One end portion 832 of the wiring member 83 is connected to the back electrode of the cell 102, and the other end portion 833 of the wiring member 83 is connected to the back electrode of the cell 103. In the solar cell module, the portions 821 and 831 of wiring members 82 and 83 which are situated in gaps between adjacent solar cells are exposed to the light-receiving side, and thus are visible from the outside.

A plurality of solar cells are connected in series by connecting the p-side electrode of one of two adjacent cells to the n-side electrode of the other cell through the wiring member. The cells can also be connected in parallel by connecting n-side electrodes or p-side electrodes of adjacent cells.

The solar cell wiring member used in the solar cell module of the present invention is used for electrical connection of a plurality of cells. The wiring member has a first principal surface, a second principal surface and lateral surfaces, and in the solar cell string, the wiring member is disposed in such a manner that the first principal surface is on the light-receiving side, and the second principal surface is on the back side. At an interconnection of the back contact solar cell, the first principal surface of the wiring member is connected to the back electrode of the cell.

Preferably, the material of the wiring member has a low resistivity for reducing a current loss caused by resistance or the wiring member. In particular, a metallic material mainly composed of copper is especially preferable because it is inexpensive.

In the wiring member, an electroconductive black layer is disposed on the entire first principal surface of a base material such as a copper foil. By disposing the electroconductive black layer on the entire first principal surface, light reflection at the portions 821 and 831 situated in the gaps between solar cells and exposed to the light-receiving surface is reduced. Thus, when the module is viewed from the light-receiving side, the colors of the exposed portion of the wiring member and the cell are unified, so that the visuality of the module is improved.

An electroconductive black layer may be disposed on the lateral surface of the wiring member as in the case of the first principal surface. By disposing an electroconductive black layer on the lateral surface, deterioration of the visuality due to visibility of reflected light of light applied to the lateral surface of the wiring member can be prevented. In a use environment of the solar cell module, the second principal surface of the wiring member is not visible from the light-receiving side, and therefore there is no special influence on the visuality of the module. Thus, the second principal surface of the wiring member may be provided with a black layer, or is not required to be provided with a black layer. When an electroconductive black layer is formed on a surface of the wiring member by plating or the like, the entire first principal surface, the entire lateral surfaces and the entire second principal surface may be provided with an electroconductive black layer.

Examples of the material of the electroconductive black layer disposed on the surface of the wiring member include alloys containing copper and nickel, chromium, zinc or the like, metal oxides, and metals in which carbon nanotubes, carbon or the like are dispersed. A metal layer containing palladium may be formed as the electroconductive black layer. Examples of the material of the metal layer containing palladium include metallic palladium and alloys containing palladium. Examples of the alloy containing palladium include Pd-Cu alloys. Palladium and a palladium alloy have high wettability to solder, and therefore have an advantage that even when an electroconductive black layer is formed on the entire first principal surface of the wiring member, it is possible to easily perform solder connection between the cell and the wiring member.

The method for forming an electroconductive black layer on a surface of the base material is not particularly limited, and a dry process such as a sputtering method, a CVD method, a vacuum vapor deposition method, or a wet process such as application of a metal paste material is applicable. The electroconductive black layer may be a plated layer formed by electroplating or electroless plating. The copper alloy layer containing palladium can be formed by electroless plating.

The entire first principal surface of the wiring member has a recessed and projected structure. By forming recessed and projected structure on the first principal surface of the wiring member, light reflection at portions 821 and 831 situated in gaps between solar cells and exposed to the light-receiving surface is reduced, and the recessed and projected structure on the first principal surface of the wiring member are closely similar in visual impression to the visual impression of the recessed and projected structure on the light-receiving surface of the cell, so that the visuality of the module is improved. For unifying the cell and the wiring member in terms of a visual impression, the shape of the recessions and projections on the light-receiving surface of the cell is preferably closely similar to the shape of the recessions and projections on the first principal surface of the wiring member.

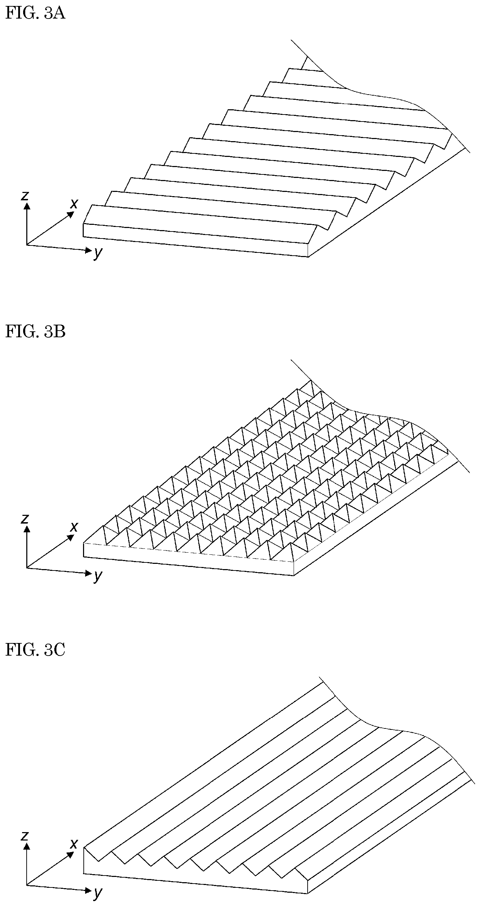

When a recessed and projected structure having a quadrangular pyramidal shape is provided on the light-receiving surface of the cell, projection of the recessed and projected structure on the first principal surface of the wiring member has a triangular prism shape as shown in FIG. 3A or a quadrangular pyramidal shape as shown in FIG. 3B. Since the triangular prism or the pyramid has a rectangular shape at the top of the projection, and is closely similar in visual impression to the quadrangular pyramidal recessed and projected structure on the light-receiving surface of the cell, the cell and the wiring member are unified in terms of a visual impression, so that the visuality of the module is improved.

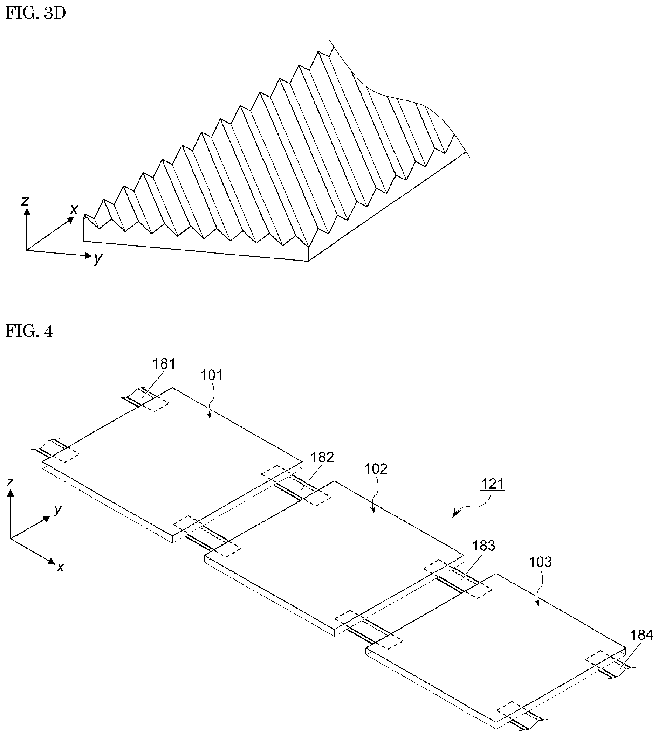

The arrangement of projections of the recessed and projected structure is not particularly limited. When the shape of the projection is a triangular prism shape, the extending direction of the triangular prism may be orthogonal to the extending direction (x direction) of the wiring member as shown in FIG. 3A, or the extending direction of the triangular prism may be parallel to the extending direction of the wiring member as shown in FIG. 3C. In addition, as shown in FIG. 3D, a triangular prism may extend in a direction which is not orthogonal or parallel to the extending direction of the wiring member, but forms a predetermined angle with the extending direction of the wiring member. When the shape of the projections is a pyramidal shape, the tops of the projections may be arranged in a square lattice shape as shown in FIG. 3B, or arranged zigzag.

The height of the projection of the recessed and projected structure on the first principal surface of the wiring member is preferably about 0.1 to 500 µm. When the height of the projections of the wiring member is 0.1 µm or more, there is a difference in visual impression between the wiring member and the smooth shape, and the cell surface and the wiring member can be made closely similar to each other in visual impression. When the height of the projections on the wiring member is 500 µm or less, it is possible to form projections having a height equal to or less than the thickness of the wiring member, and the wiring member is not required to have an excessively large thickness. Thus, the flexibility and handling property of the wiring member can be maintained. The height of the recessed and projected structure of the wiring member is more preferably 0.5 to 20 µm. When the height of the projections on the wiring member is within the above-mentioned range, the projections on the wiring member are further closely similar in size to the projections on the cell, resulting in contribution to improvement of the visuality by making the projection shapes of the wiring member and the cell as similar to each other as possible.

The method for forming a recessed and projected structure on the surface of the wiring member is not particularly limited. For example, recessions and projections may be mechanically formed by a pressing method or the like, or recessions and projections may be chemically formed by wet etching. For improving the visuality of the module by making the visual impression of the cell closely similar to the visual impression of the wiring member, a recessed and projected structure with regularity, in which projections are regularly arranged, is formed on the first principal surface of the wiring member. A recessed and projected structure with regularity can be formed on the surface of the wiring member by a mechanical method such as a method in which a recessed and projected shape of a roll surface is transferred to a base material surface.

In the present invention, the first principal surface has a recessed and projected structure and equipped with electroconductive black layer not only at the exposed portions 821 and 831 on the light-receiving surface of the wiring members 82 and 83, but also at the connection portions 822, 823, 832 and 833 between the wiring members 82 and 83 and the cell. Since the black layer for preventing light reflection has electroconductivity, contact resistance between the electrode of the cell and the wiring member is small, so that an electric power loss can be reduced. In addition, since a recessed and projected structure is formed at the connection portion of the wiring member with the cell, the contact area between the wiring member and an electroconductive connection material such as solder or a conductive adhesive is increased, so that bonding strength between the wiring member and the cell tends to be improved by an anchor effect.

When the electroconductive black layer is disposed and a recessed and projected structure is formed on the entire first principal surface of the wiring member, patterning or the like is not needed, and therefore the wiring member can be manufactured at low cost. In addition, since severe accuracy of alignment is not required in connection of the cell to the wiring member, the productivity and the yield of the solar cell module can be improved.

In preparation of the module, a solar cell string is first prepared by mutually connecting a plurality of cells through the wiring member. The electrode of the cell is connected to the wiring member through an electroconductive connection material such as solder, a conductive film or a conductive paste. Since the electroconductive connection member has metallic luster, the visuality of the module may be deteriorated when the electroconductive connection member is viewed from the outside. Thus, it is preferable that the electroconductive connection member is disposed only in a region which is not visible from the light-receiving surface of the module, and the electroconductive connection material is not disposed in a region visible from the light-receiving surface.

For example, in connection of the electrode on the light-receiving surface of the cell and the wiring member, it is preferable to dispose electroconductive connection material in such a manner that the electroconductive connection material is not protruded from the region where the wiring member is disposed. Since the back side of the cell is not visible from the light-receiving surface of the module, there is no particular problem even if the electroconductive connection material is protruded from the region where the wiring member is disposed. However, since the portions 821 and 831 situated in gaps between adjacent cells are viewed from the light-receiving surface, it is preferable that the electroconductive connection material is not provided in this region.

The solar cell string with a plurality of cells connected through the wiring member is sandwiched between a light-receiving-surface protection member 91 and a back-surface protection member 92 with an encapsulant 95 interposed between each of the protection members and the solar cell string, thereby forming the solar cell module. Preferably, a laminate in which the light-receiving-side encapsulant, the solar cell string, the back-side encapsulant and the back-surface protection member are mounted in this order on the light-receiving-surface protection member is heated at predetermined conditions to cure the encapsulant.

Preferably, a transparent resin such as a polyethylene-based resin composition mainly composed of an olefin-based elastomer, polypropylene, an ethylene/α-olefin copolymer, an ethylene/vinyl acetate copolymer (EVA), an ethylene/vinyl acetate/triallyl isocyanurate (EVAT), polyvinyl butyrate (PVB), silicon, urethane, acrylic or epoxy is used as the encapsulant 95. Materials of the encapsulants on the light-receiving side and the back side may be the same or different.

For the light-receiving-surface protection member 91, which is light-transmissive, glass, transparent plastic or the like is used. The back-surface protection member 92 may be any of light-transmissive, light-absorptive and light-reflective. A light-absorptive black sheet may be used as the back-surface protection member for unifying the colors of the cell and the wiring member to improve the visuality of the solar cell module.

As the black sheet, for example, one including a black resin layer is used. The black resin layer has visible light-absorbency, and mainly absorbs visible light having a wavelength of 800 nm or less. The visible light transmittance of the black resin layer is preferably 10% or less. As a black resin layer, a resin composition containing a thermoplastic resin such as a polyolefin-based resin, a polyester-based resin, an acryl-based resin, a fluororesin or an ethylene-vinyl acetate resin and a colorant such as a pigment or a dye is preferably used.

When a back-surface protection member including a black resin layer is used, the back-surface protection member is similar in appearance color to the cell, and therefore gaps between separately arranged cells are inconspicuous, so that a module having a high visuality is obtained. In the present invention, a wiring member having a predetermined shape is used, so that the metallic color of the wiring member is hardly visible because reflected light from the wiring member is not emitted outside from the light-receiving side of the module as described in detail later. Thus, by using a light-absorptive back-surface protection member, a module is obtained which is uniformly colored black in its entirety, and has a high visuality.

As described above, by using the wiring member in the solar cell module of the present invention, the entire surface can be uniformly colored black when the solar cell module is viewed from the light-receiving side. In addition, since a recessed and projected structure is formed not only on the light-receiving surface of the solar cell, but also on the surface of the wiring member, the solar cell and the wiring member are unified in terms of a visual impression, and thus the wiring member becomes more difficult to view, so that a solar cell module having a high visuality is obtained.

Although FIG. 2 shows a configuration in which the wiring member is disposed over substantially the total length in a cell connection direction, the shape of the wiring member is not limited to the configuration shown in FIG. 2. For example, as in a solar cell string 121 shown in FIG. 4, the electrodes of adjacent cells may be connected by band-shaped wiring members 181, 182 and 183 extending in a cell connection direction. The shape of the wiring member and the number of wiring members may be appropriately designed according to the electrode structure of the cells, etc.

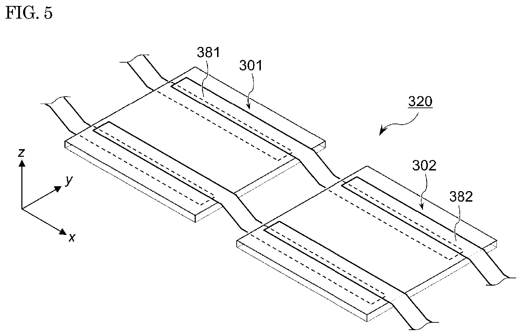

The wiring member used in the solar cell module of the present invention is used for interconnection of back contact solar cells. In an example not being part of the present invention, the above described wiring member can be used for interconnection of double-sided electrode type solar cells. In the interconnection of double-side junction type solar cells, the second principal surface of a wiring member 381 is connected to a light-receiving surface electrode of one cell 301 of two adjacent cells 301 and 302, and the first principal surface of a wiring member 381 is connected to a back electrode of the other cell 302 as shown in FIG. 5.

In this configuration, the wiring member is exposed to the light-receiving surface not only in a gap between adjacent cells but also at a connection portion of the cell with the light-receiving surface electrode. The electroconductive black layer is disposed on the entire surface of the wiring member, and recessed and projected structure is formed, and therefore even when any portion of the first principal surface of the wiring member is exposed to the light-receiving side, the wiring member is unified with the solar cell in terms of a visual impression, so that a module having a high visuality is obtained.

### DESCRIPTION OF REFERENCE SIGNS

101 to 103, 301, 302 solar cell
81 to 84, 181 to 184, 381, 382 wiring member
120, 121, 320 solar cell string
91 light-receiving-surface protection member
92 back-surface protection member
95 encapsulant
200 solar cell module

## Claims

1. A solar cell module comprising:
a solar cell string (120) in which a plurality of solar cells (101, 102, 103) each having a light-receiving surface and a back surface are electrically connected through a wiring member (82, 83);
a light-transmissive light-receiving-surface protection member (91) disposed on a light-receiving side of the solar cell string;
a back-surface protection member (92) disposed on a back side of the solar cell string; and
an encapsulant (95) disposed between the light-receiving-surface protection member and the back-surface protection member to encapsulate the solar cell string,
wherein
the solar cell has no metal electrode on the light-receiving surface, and a metal electrode is disposed only on the back surface of the solar cell,
the wiring member has a first principal surface, a second principal surface and lateral surfaces,
the metal electrode on the back surface of the solar cell is connected to the first principal surface of the wiring member,
**characterizing in that**
the light-receiving surface of the solar cell has a recessed and projected structure, and the recessed and projected structure on the light-receiving surface of the solar cell has a quadrangular pyramidal shape
the entire first principal surface of the wiring member has a recessed and projected structure, each of projections of the recessed and projected structure on the first principal surface of the wiring member has a triangular prism shape or a pyramidal shape, and the projections are regularly arranged, and
an electroconductive black layer is disposed on the entire first principal surface of the wiring member.

2. The solar cell module according to claim 1, wherein a projection of the recessed and projected structure on the first principal surface of the wiring member has a height of 0.1 to 500 µm.

3. The solar cell module according to claim 1 or 2, wherein the electroconductive black layer is also disposed on the lateral surface of the wiring member.

4. The solar cell module according to any one of claims 1 to 3, wherein a base material of the wiring member is copper.

5. The solar cell module according to any one of claims 1 to 4, wherein the electroconductive black layer is a plated layer formed on a surface of a base material of the wiring member.

6. The solar cell module according to any one of claims 1 to 5, wherein the electroconductive black layer is a metal layer containing palladium.

7. The solar cell module according to any one of claims 1 to 6, wherein an electroconductive connection material for electrically connecting the electrode of the solar cell to the wiring member is not disposed in a region visible from a light-receiving surface side.

8. The solar cell module according to any one of claims 1 to 7, wherein the metal electrode disposed on the back surface of the solar cell and the first principal surface of the wiring member are connected to each other with solder.

9. The solar cell module according to any one of claims 1 to 8, wherein the back-surface protection member is a black sheet.

## Patentansprüche

1. Solarzellenmodul, umfassend:
eine Solarzellenkette (120), in der mehrere Solarzellen (101, 102, 103), die jeweils eine Lichtempfangsfläche und eine Rückfläche aufweisen, durch ein Verdrahtungselement (82, 83) elektrisch verbunden sind;
ein lichtdurchlässiges Lichtempfangsflächen-Schutzelement (91), das auf einer Lichtempfangsseite der Solarzellenkette angeordnet ist;
ein Rückflächen-Schutzelement (92), das auf einer Rückseite der Solarzellenkette angeordnet ist; und
ein Verkapselungsmaterial (95), das zwischen dem Lichtempfangsflächen-Schutzelement und dem Rückflächen-Schutzelement angeordnet ist, um die Solarzellenkette zu verkapseln,
wobei
die Solarzelle keine Metallelektrode auf der Lichtempfangsfläche aufweist und eine Metallelektrode nur auf der Rückfläche der Solarzelle angeordnet ist,
das Verdrahtungselement eine erste Hauptoberfläche, eine zweite Hauptoberfläche und seitliche Flächen aufweist,
die Metallelektrode auf der Rückfläche der Solarzelle mit der ersten Hauptoberfläche des Verdrahtungselements verbunden ist, **dadurch gekennzeichnet, dass**
die Lichtempfangsfläche der Solarzelle eine vertiefte und vorstehende Struktur aufweist, und die vertiefte und vorstehende Struktur auf der Lichtempfangsfläche der Solarzelle eine viereckige Pyramidenform aufweist
die gesamte erste Hauptoberfläche des Verdrahtungselements eine vertiefte und vorstehende Struktur aufweist, jeder der Vorsprünge der vertieften und vorstehenden Struktur auf der ersten Hauptoberfläche des Verdrahtungselements eine dreieckige Prismenform oder eine Pyramidenform aufweist, und die Vorsprünge regelmäßig angeordnet sind, und
eine elektrisch leitende schwarze Schicht auf der gesamten ersten Hauptoberfläche des Verdrahtungselements angeordnet ist.

2. Solarzellenmodul nach Anspruch 1, wobei ein Vorsprung der vertieften und vorstehenden Struktur auf der ersten Hauptoberfläche des Verdrahtungselements eine Höhe von 0,1 bis 500 µm aufweist.

3. Solarzellenmodul nach Anspruch 1 oder 2, wobei die elektrisch leitende schwarze Schicht auch auf der seitlichen Fläche des Verdrahtungselements angeordnet ist.

4. Solarzellenmodul nach einem der Ansprüche 1 bis 3, wobei ein Basismaterial des Verdrahtungselements Kupfer ist.

5. Solarzellenmodul nach einem der Ansprüche 1 bis 4, wobei die elektrisch leitende schwarze Schicht eine plattierte Schicht ist, die auf einer Oberfläche eines Basismaterials des Verdrahtungselements ausgebildet ist.

6. Solarzellenmodul nach einem der Ansprüche 1 bis 5, wobei die elektrisch leitende schwarze Schicht eine Metallschicht ist, die Palladium enthält.

7. Solarzellenmodul nach einem der Ansprüche 1 bis 6, wobei ein elektrisch leitendes Verbindungsmaterial zum elektrischen Verbinden der Elektrode der Solarzelle mit dem Verdrahtungselement nicht in einem Bereich angeordnet ist, der von einer Lichtempfangsflächenseite sichtbar ist.

8. Solarzellenmodul nach einem der Ansprüche 1 bis 7, wobei die auf der Rückfläche der Solarzelle angeordnete Metallelektrode und die erste Hauptoberfläche des Verdrahtungselements durch Lot miteinander verbunden sind.

9. Solarzellenmodul nach einem der Ansprüche 1 bis 8, wobei das Rückflächen-Schutzelement ein schwarzes Blatt ist.

## Revendications

1. Module de cellules solaires comprenant :
une chaîne de cellules solaires (120) dans laquelle une pluralité de cellules solaires (101, 102, 103) comportant chacune une surface de réception de lumière et une surface arrière sont connectées électriquement par le biais d'un organe de câblage (82, 83) ;
un organe de protection de surface de réception de lumière transmettant la lumière (91) disposé sur un côté de réception de lumière de la chaîne de cellules solaires ;
un organe de protection de surface arrière (92) disposé sur un côté arrière de la chaîne de cellules solaires ; et
un encapsulant (95) disposé entre l'organe de protection de surface de réception de lumière et l'organe de protection de surface arrière pour encapsuler la chaîne de cellules solaires,
dans lequel
la cellule solaire est dépourvue d'électrode métallique sur la surface de réception de lumière, et une électrode métallique est disposée uniquement sur la surface arrière de la cellule solaire,
l'organe de câblage comporte une première surface principale, une seconde surface principale et des surfaces latérales,
l'électrode métallique sur la surface arrière de la cellule solaire est connectée à la première surface principale de l'organe de câblage,
**caractérisé en ce que**
la surface de réception de lumière de la cellule solaire comporte une structure en retrait et saillante, et la structure en retrait et saillante sur la surface de réception de lumière de la cellule solaire a une forme pyramidale quadrangulaire,
la première surface principale entière de l'organe de câblage a une structure en retrait et saillante, chacune des saillies de la structure en retrait et saillante sur la première surface principale de l'organe de câblage a une forme de prisme triangulaire ou une forme pyramidale, et les saillies sont agencées de façon régulière, et
une couche noire électroconductrice est disposée sur la première surface principale entière de l'organe de câblage.

2. Module de cellules solaires selon la revendication 1, dans lequel une saillie de la structure en retrait et saillante sur la première surface principale de l'organe de câblage a une hauteur de 0,1 à 500 µm.

3. Module de cellules solaires selon la revendication 1 ou 2, dans lequel la couche noire électroconductrice est également disposée sur la surface latérale de l'organe de câblage.

4. Module de cellules solaires selon l'une quelconque des revendications 1 à 3, dans lequel un matériau de base de l'organe de câblage est le cuivre.

5. Module de cellules solaires selon l'une quelconque des revendications 1 à 4, dans lequel la couche noire électroconductrice est une couche plaquée formée sur une surface d'un matériau de base de l'organe de câblage.

6. Module de cellules solaires selon l'une quelconque des revendications 1 à 5, dans lequel la couche noire électroconductrice est une couche métallique contenant du palladium.

7. Module de cellules solaires selon l'une quelconque des revendications 1 à 6, dans lequel un matériau de connexion électroconducteur pour connecter électriquement l'électrode de la cellule solaire à l'organe de câblage n'est pas disposé dans une région visible depuis un côté de surface de réception de lumière.

8. Module de cellules solaires selon l'une quelconque des revendications 1 à 7, dans lequel l'électrode métallique disposée sur la surface arrière de la cellule solaire et la première surface principale de l'organe de câblage sont connectées l'une à l'autre par brasure.

9. Module de cellules solaires selon l'une quelconque des revendications 1 à 8, dans lequel l'organe de protection de surface arrière est une feuille noire.
